(19) **Europäisches Patentamt / European Patent Office / Office européen des brevets**

(11) **EP 4 761 552 A1**

(12) **EUROPEAN PATENT APPLICATION**
published in accordance with Art. 153(4) EPC

(43) Date of publication:
**17.06.2026 Bulletin 2026/25**

(21) Application number: **24853920.7**

(22) Date of filing: **05.08.2024**

(51) International Patent Classification (IPC):
*H10N 30/05* (2023.01)    *H10N 39/00* (2026.01)
*H02N 2/18* (2006.01)    *H10N 30/30* (2023.01)
*H10N 30/50* (2023.01)

(86) International application number:
**PCT/ES2024/070500**

(87) International publication number:
**WO 2025/037043 (20.02.2025 Gazette 2025/08)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **11.08.2023 ES 202330695**

(71) Applicant: **Consejo Superior de Investigaciones Científicas (CSIC) 28006 Madrid (ES)**

(72) Inventors:
• **MURILLO RODRÍGUEZ, Gonzalo**
**08193 Cerdanyola del Vallès Barcelona (ES)**
• **DUQUE DUQUE, Marcos**
**08193 Cerdanyola del Vallès Barcelona (ES)**

(74) Representative: **Pons IP**
**Glorieta Rubén Darío 4**
**28010 Madrid (ES)**

(54) **MONOLITHIC FUNCTIONAL STRUCTURES AND METHOD FOR THE PRODUCTION THEREOF**

(57) The present invention belongs to the field of electrically powered functional structures, specifically to monolithic functional structures comprising at least one functional structure (such as a resonator, sensor, energy collector, etc.) and at least one piezoelectric material. In addition, the at least one functional structure and the at least one piezoelectric material form part of a single piece and are electrically connected together. The invention relates to the monolithic functional structure and to a method for 3D printing the monolithic functional structure.

EP 4 761 552 A1

## Description

### Field of the invention

The present invention belongs to the field of electrically-powered functional structures, specifically to monolithic functional structures comprising at least a functional structure (such as a resonator, a sensor, an energy harvester, etc.) and at least a piezoelectric material. The invention refers both to such a monolithic functional structure, and to a method for 3D printing such monolithic functional structure.

### Background art

There is a need to provide reliable and non-wasteful electrical energy sources for functional structures (such as resonators, sensors, energy harvesters, etc.) which require the use of electrical energy and are highly dependent on such electrical energy source.

For example, the large increase in the Internet of Things (IoT) has led to a huge growth in the development of very low-power sensors that communicate with each other and form a large wireless network. The greatest difficulty in the expansion of the IoT is the energy dependence of the sensors, limited by the use of their batteries. For this reason, we are facing a great barrier due to the high cost of replacing batteries and the environmental impact that it entails. Other monolithic functional structures (resonators, sensors, energy collectors, etc.) face the same shortcomings due to their dependence on electric energy from batteries.

The current solution is to provide batteries as an electrical power source for these functional structures (such as sensors). However, batteries entail a shortcoming due to their high cost, their need for replacement, and the associated environmental impact.

Hence, an alternative for the supply of electrical energy to such functional structures (such as sensors) is required in the field which overcomes these shortcomings. Such alternative with its corresponding advantages is the object of this patent application and will be made apparent throughout its description.

### Summary of the invention

On the one hand, there are materials such as piezoelectric materials, which allow harvesting residual environmental energy (such as movement, vibrations, magnetic fields, light, heat, etc.) and converting it into electrical energy. An example of a device which can convert mechanical energy into electrical energy are piezoelectric transducers. In vibrational energy harvesting, piezoelectric materials are one of the most widely used transducers. An example of such piezoelectric materials are piezoceramics, such as the lead zirconate titanate (PZT). An advantageous piezoelectric material is PVDF and its copolymers since it does not contain toxic materials such as lead.

On the other hand, there exists the technique of three dimensional (3D) printing or additive manufacturing (AM), which is a process of making three-dimensional solid objects from a digital file. This technique allows the production of many custom-designed products, in a wide array of fields including agriculture, healthcare, automotive, aerospace, etc.

Briefly, AM technologies are based on three types of processes:

1) Synthesis, in which the temperature of the material is raised without liquefying it to create high-resolution prototypes,
2) Fusion, in which powders are fused by means of electron beams, and
3) Stereolithography, which uses a method called photopolymerization, which uses an associated ultraviolet laser.

The present invention proposes to integrate together a monolithic functional structure (resonators, sensors, energy harvesters, etc.; preferably a low power sensor) and at least one piezoelectric material (which converts ambient energy into electrical energy usable by the monolithic functional structure), to be produced by 3D printing, in order to create monolithic 3D piezoelectric devices. The functional structure carries out the intended function of the device (that of a resonator, a sensor, an energy harvester, etc.), while the piezoelectric material converts the residual energy of the device and the environment into electrical energy to be used by the functional structure.

The term "functional structure" according to the present invention refers to a mechanical structure capable of exerting a mechanical stress on the piezoelectric layer, typically a resonator or mechanical stressor, which causes a reaction in the electrical device so that the device carries out its corresponding function or purpose of sensor, low-power sensor, energy harvester or actuator device.

The term "low power sensor" is known in the state of the art and refers to sensors that work using little energy or power. When several low power sensors connected in networks they operate as a type of wireless technology. This means that they have the benefits of wide-area mobile networks at a lower cost. They do not allow for large data transfers, so are not used for human communications (voice, video, and other communications that transfer large volumes of data). However, their capacity to connect devices across wide distances makes them useful for Internet of Things (IoT) technologies and other machine-to-machine communications. Long-range, low-power sensor networks can be deployed over large areas to collect data that can be analysed and developed into predictive models to drive strategic decisions. They can also be integrated into existing products to add intelligent features that will make them more appealing to users and to gather usage data to improve their performance over time.

The term "functional structure material" according to the present invention refers to the type of material that is used to fabricate the functional structure.

The term "piezoelectric material" according to the present invention refers to any material which is capable of transforming residual or environmental energy into electrical energy.

The term "monolithic" in "monolithic functional structure" according to the present invention, refers to the fact that components of such structure, including the at least one functional structure and the at least one piezoelectric material, are integrated within a single piece or structure, or are part of a single piece or structure.

The term "compact" according to the present invention refers to the fact that the different components are connected with physical direct contact between them, and without the need for loose parts or assembled part to connect them.

A non-limiting example of such a monolithic piezoelectric device is a sensor functional structure (such as a low power sensor) together with a PVDF piezoelectric material. For example, a compact and electrically bonded sensor and PVDF material, printed as a single piece by 3D printing. Another non-limiting example is a piezoelectric energy harvester, such as an energy harvester together with a PVDF piezoelectric material.

Examples of piezoelectric materials to be used according to the invention are lead zirconate titanate (PZT), polyvinylidene fluoride (PVDF) or their copolymers, like PVDF-TrFE (copolymer of polyvinylidene fluoride and trifluoroethylene) and PVDF-TeFE (copolymer of polyvinylidene fluoride and tetrafluoroethylene), and their combinations thereof.

Therefore, this solution allows, by 3D printing in a single printing step, obtaining a compact part which comprises both components (at least a functional structure and a piezoelectric material) integrated within, which in addition to comprising and performing the function of the functional structure, also allows the collection of environmental energy and its transformation into electrical energy by the piezoelectric material.

The 3D printing method to obtain monolithic functional structures according to the invention, results in the advantages of being an easier, cheaper, and highly customizable method (compared to other fabrication methods of functional structures such as a sensor) and allows simultaneously producing the functional structure and the piezoelectric material in the same printing process and as a single piece, without the need for assembling different parts.

In fact, the 3D printing of monolithic functional structures according to the invention, is simpler since it does not require to further assembly steps or tools and does not require molds. Moreover, it allows rapid and customizable changes of design and the easy fabrication of complex monolithic functional structures. What is more, the 3D printing method according to the invention also allows integrating computer-implemented design software (such as CAD), which allows the full-customization of the monolithic functional structures, for example allowing their full adaptation to the environmental conditions in which such structure is planned to be used.

The obtained monolithic functional structure is compact, is cheaper, and has very low environmental impact since its electrical energy source (the piezoelectric material) does not need to be replaced or disposed of, and the structure is capable of reusing residual energy from the structure or its environment. Moreover, the compactness of the monolithic functional structure is advantageous in making the piezoelectric material contained within more efficient in converting the residual energy of the part (mechanical, light, heat) into electrical energy, due to the fact that its compactness and integration avoid losses due to electrical transmission, because the device itself has its own support and does not need to be externally attached to a support. In other words, the better bonding between the functional structure and the piezoelectric material, helping to convert and transmit more of the residual energy into electrical energy to be used by the functional structure.

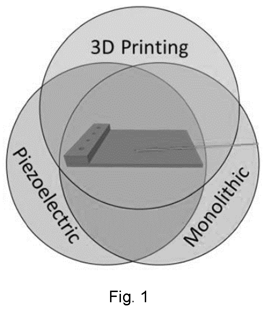

Figure 1 illustrates schematically the advantage of integrating piezoelectric materials by 3D printing to create monolithic 3D-printed piezoelectric devices, according to the present invention. In this way, it is possible to adapt the functional structure (such as a resonator, an energy harvester, or a sensor, etc.) to the different needs, and with its own self-integrated electrical energy source, in a fully customizable manner, and without the need for subsequent assembly which entails an easier and cheaper production method, as well as a cheaper final product device.

The invention hence refers to the fabrication of monolithic functional structures (such as resonators, sensors, energy harvesters), by using 3D printing, and by printing in the same process the layers of the functional material and the piezoelectric material. Preferably, the three-dimensional (3D) printing technique used to produce the monolithic functional structures of the present invention is Fused Deposition Modeling, which is a process of material extrusion used to fabricate thermoplastic pieces by extrusion and deposition of materials layer by layer.

A first aspect of the invention refers to a monolithic functional structure, characterized in that is comprises:

- at least a functional structure made of a functional structure material; and
- at least a piezoelectric material;
- wherein the functional structure and the piezoelectric material are part of a single piece;
- wherein the functional structure and the piezoelectric material are electrically connected; and
- wherein the piezoelectric material is not located along the neutral axis of the monolithic functional structure.

The "neutral axis" in the present invention herein refers to the axis across the monolithic functional structure along which there are no longitudinal stresses or strains.

The functional structure is a mechanical structure capable of mechanically stressing the piezoelectric layer, typically a resonator or a mechanical stressor.

The device, that is the monolithic functional structure, further comprise a substrate (for example a glass substrate) on top of which the functional structure and the piezoelectric material are located. 3D printing of the at least a functional structure and of the at least a piezoelectric material, is carried out on top of the substrate.

The at least one piezoelectric material can collect the residual environmental energy (for example movement, vibrations, magnetic fields, light, heat, etc.) and transform it into electrical energy, which can be used by the functional structure of the monolithic functional structure to power it so that it can carry out its function. This allows the electrical powering of the functional structure which carries out the function of interest of the device (for example a sensor) without the need for batteries or external power sources.

In a preferred embodiment, the functional structure material of the monolithic functional structure is selected from PLA (polylactic acid), ABS (acrylonitrile butadiene styrene), PVA (polyvinyl alcohol), PP (polypropylene), tough PLA (tough polylactic acid), CPE (co-polyester), PET-G (glycol-modified polyethylene terephthalate), Nylon (polyamide), PC (polycarbonate), and any combination. Preferably the functional structure material is selected from PLA or tough PLA or combinations thereof, more preferably tough PLA.

The term "tough PLA or tough polylactic acid" as used herein refers to a special type of PLA, called Tough PLA, combines the ease of printing with increased mechanical performance. Specifically, tough PLA has increased impact resistance, avoiding the typical brittle failure of normal PLA. Tough PLA is used for functional prototyping tooling and manufacturing aids.

In another preferred embodiment, the functional structure material is a printed material. In another more preferred embodiment, the functional structure material comprising at least one layer of printed structural material. In another even more preferred embodiment, the functional structure material has a region of the said layer of functional structure material is left empty as a depression. In another a most preferred embodiment, the functional structure material comprising more than one layer of printed structural material wherein said left empty region is located on the top and last structural printed layer.

In another preferred embodiment, the piezoelectric material of the monolithic functional structure is zirconate titanate (PZT), polyvinylidene fluoride (PVDF) or their copolymers, such as PVDF-TrFE (copolymer of polyvinylidene fluoride and trifluoroethylene), PVDF-TeFE (copolymer of polyvinylidene fluoride and tetrafluoroethylene), or combinations thereof.

In another preferred embodiment, the substrate material is selected from glass, metal such as gold, silver, copper, aluminum, iron, nickel, titanium, platinum, cobalt, lithium. Preferably the substrate is glass. Moreover, once the monolithic functional structure is fabricated, the substrate can be either kept as part of the monolithic functional structure or be removed from it.

In another preferred embodiment, the functional structure of the monolithic functional structure is a low-power sensor.

In another preferred embodiment, the monolithic functional structure is a monolithic energy harvester structure with PVDF as the piezoelectric material.

In another preferred embodiment, the at least one functional structure and the at least one piezoelectric material of the monolithic functional structure, are at least in partial physical contact with each other. The advantage of said embodiment is that by being in direct contact, the conversion of residual energy and thus the transformation into electrical energy is more efficient.

In another preferred embodiment, the monolithic functional structure further comprising a conductor material, preferably said conductor material is selected from an electrically conductor wire, a conductive track and a metal layer, such as gold, silver, copper, iron, nickel, titanium, platinum, cobalt; more preferably the conductor material is a metal layer, more preferably is a copper metal layer.

In another more preferred embodiment, the conductor material is located in contact with the functional structure.

In another preferred embodiment, the monolithic functional structure is characterized in that it comprises from bottom to top:

- at least a first layer of functional structure material comprising at least one layer of printed structural material, wherein a region of the said layer of functional structure material is left empty as a depression, wherein a metal layer, preferably copper, applied in such region;

- at least a second layer of functional structure material comprising at least one layer of printed structural material on top of the first layer of functional structure material, wherein at least the top of the metal layer is left uncovered;
- a layer of piezoelectric material on top of the first layer of functional structure material, at least partially in contact with the metal layer;
- at least a third layer of functional structure material comprising at least one layer of printed structural material on top of the piezoelectric material layer and on top of the second layer of functional structure material, wherein at least a region on the top of the metal layer and a region on the top of the piezoelectric material layer are left uncovered;
- an electrical connector selected from a metal wire or a metal spring load, located in both of the regions left uncovered on top of the metal layer and on top of the piezoelectric material layer.

The electrical connector may be any type of connector which allows a connection between the metal layer and the piezoelectric material layer.

The term "structural layer or first, second, third structural layer" in the present invention refers to a layer that comprising at least one layer of the structural layer material a layer obtained by any method, whether by printing, by the additive method or by any deposition technique known to the state of the art. Evidently, it contains as many layers of material as necessary in any functional structure material layer or in the first, second or third structural layers indicated; and where in the first and second layers, the last layer of material that makes up each structural layer has an area without material leaving a gap to house the metallic layer or the corresponding piezoelectric. The combination of the different layers of structural material together constitutes the functional structure of the device.

The monolithic functional structure may comprise at the bottom a substrate, in the case that the substrate on which the 3D printing of the monolithic functional structure was carried out, is not finally removed from such structure.

A second aspect of the invention refers to a method for the 3D printing of monolithic functional structures, characterized in that it comprises the steps of:

　　a. providing a substrate, preferably a glass substrate;

　　b. printing at least one layer of a first functional structure material that comprising at least one layer of printed structural material on the substrate of the step (a), preferably PLA, without applying functional structure material to at least a region of the last printing layer;

　　c. applying metal in such a region of the step (b), preferably copper,

　　d. optionally, printing at least one layer of a second functional structure material that comprising at least one layer of printed structural material, preferably PLA, without applying functional structure material at least on top of the region where the metal has been applied in step (c),

　　e. applying a piezoelectric material, preferably polyvinylidene fluoride, on top of the layer where the metal has been applied in step (c), preferably at least partially in direct contact with the metal,

　　f. printing at least one layer of a third functional structure material that comprising at least one layer of printed structural material, preferably PLA, without applying functional structure material on top of at least a region of the metal of step (c) and on top of at least a region of the piezoelectric material of step (e), and

　　g. placing at least an electrical connector in both of the regions left uncovered on top of the metal and on top of the piezoelectric material of step (f).

In a preferred embodiment according to the second aspect of the invention, the 3D printing is carried out by Fused Deposition Modelling.

In another preferred embodiment according to the second aspect of the invention, the method uses computer-implemented design (CAD) software in order to design the monolithic functional structure to be 3D printed.

In another preferred embodiment according to the second aspect of the invention, a model created by computer-implemented design (CAD) software is sliced into layers using slicing software.

In another preferred embodiment according to the second aspect of the invention, the applied metal in step c) of the method is selected from gold, silver, copper, aluminum, iron, nickel, titanium, platinum, cobalt, lithium, or their alloys; preferably copper.

In another preferred embodiment according to the second aspect of the invention, the at least one electrical connector placed in both of the regions, in step g) of the method, is selected from a metal wire or a metal spring load.

In another preferred embodiment according to the second aspect of the invention, the metal of the metal wire or metal spring load is selected from gold, silver, copper, aluminum, iron, nickel, titanium, platinum, cobalt, lithium, or their alloys; preferably copper.

In another preferred embodiment according to the second aspect of the invention, the functional structure material is selected from PLA (polylactic acid), ABS (acrylonitrile butadiene styrene), PVA (polyvinyl alcohol), PP (polypropylene), PLA Tough, CPE (co-polyester), PET-G (glycol-modified polyethylene terephthalate), Nylon (polyamide) and PC (polycarbonate) and any combination thereof; preferably PLA, and even more preferably tough PLA.

In another preferred embodiment the substrate is selected from glass, metal such as gold, silver, copper, aluminum, iron, nickel, titanium, platinum, cobalt, lithium. Preferably the substrate is glass.

In another preferred embodiment the process further comprises an additional step of removing the substrate of the monolithic material obtained in step (g).

A third aspect of the invention refers to the use of monolithic functional structure described above as a sensor, low-power sensor, self-powered sensor, energy harvester or actuator.

In another preferred embodiment the use of the monolithic is as a low-power sensor for the creation of a large wireless network wherein the low-power sensors communicate with each other.

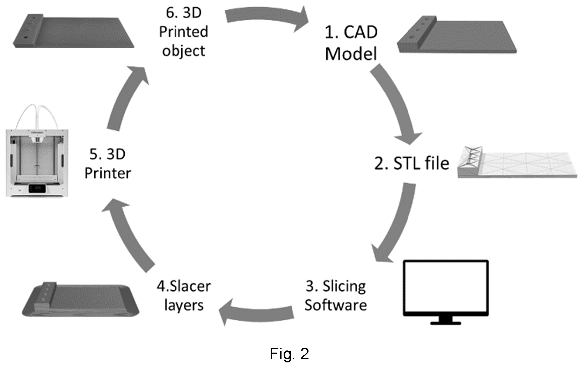

In 3D printing, as can be seen in Figure 2 the process begins with designing the desired piece using 3D design software, typically design CAD software (for example Tinkercad, https://www.tinkercad.com). This design by CAD software allows to optimize both the function of the device as well as the collection and conversion of residual environmental energy into electrical energy by the piezoelectric material. Once the design is completed, the next step is exporting the file in STL (Stereolithography) format. The STL file contains all the necessary information about the 3D object. Subsequently, the CAD model is sliced into layers using slicing software such as "Ultimaker Cura 4.13.1". Finally, the object is printed by transferring the file, positioning and printing the design layer-by-layer. This process is schematically summarized in Figure 2.

The 3D printing manufacturing process according to the invention process additionally includes two additional steps, in order to introduce the bottom electrode and the piezoelectric material (such as PVDF material).

The piezoelectric material preferably comprises two metallic electrodes, noted in this description as "bottom electrode" and "top electrode". The bottom electrode and the top electrode may be made of any electrically conducting metal, for example gold, silver, copper, aluminum, iron, nickel, titanium, platinum, cobalt, lithium, etc; preferably copper.

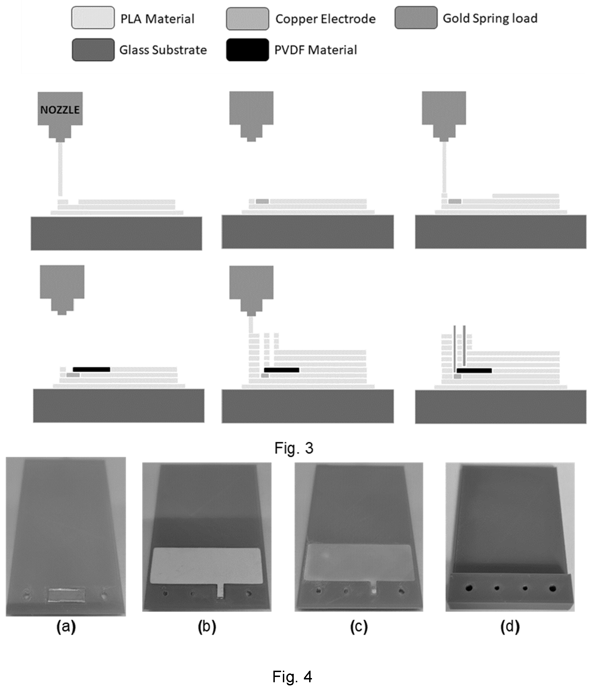

The first step (as shown in Figure 3a), is providing a substrate (for example a glass substrate) onto which to print the monolithic functional structure. First of all, some layers of a "functional structure material" (such as PLA) are printed onto the substrate, layers which will serve as the bottom of the final structure which will encapsulate the piezoelectric material within the structure (Figure 3a). Hence, the material of this encapsulation layer will be referred to as "functional structure material". It was observed that the thinner the printing layer of functional structural material, the greater the power output from the printed monolithic functional structure. Preferably, the thickness layer to be printed by the nozzle for each printing layer is between 60-150 $\mu$m, even more preferably 100 $\mu$m, which allows to ensure good quality and avoid pushing the limits of the printer head.

The bottom of the encapsulating layer preferably comprises two to three printed layers. This low number of layers (2-3 layers) will help to maintain the high quality of the encapsulating layer and also increase the stress received by the piezoelectric material, which increases the electricity generated by the piezoelectric material. The more stress is achieved, the more charge is generated in the piezoelectric material. Additionally, a small region (such as a hole) is left uncovered on the material's surface, at least left unprinted in the last printing layer. In this small region (such as a hole) the metal that will serve as the electrode will be placed (for example a lower copper electrode).

Subsequently, metal or a metal piece (for example a copper piece) is applied inserted to establish the connection with the bottom electrode, in such small region (as shown in Figure 3b).

At this stage, optionally and additionally one or more layers of the encapsulating material (such as PLA) can be applied on top of the previously applied encapsulating material layers, as long as the small region (such as a hole) where the metal for the electrode has been applied, is left uncovered (Figure 3c).

Then, a layer of piezoelectric material is printed by the nozzle and deposited on top of the metal electrode material, such that the piezoelectric material is at least partially in direct contact with the metal electrode material (as shown in Figure 3d). Afterwards, the remainder of the encapsulating layer material (such as PLA) is printed layer by layer, such that the remainder of the monolithic functional structure is printed (as shown in Figure 3e). In the final printing stage, at least a partial area of both the electrode material (for example copper) and the piezoelectric material (for example PVDF) are left uncovered (as shown in Figure 3e). This allows that, upon completing the print, electrical connectors (metal connectors such as metal wires or metal spring loads, preferably gold connectors) are inserted to facilitate the connection between the at least one copper electrode and the piezoelectric material (as shown in Figure 3f).

The material to be printed layer-by-layer for the encapsulating layer according to the invention can be any polymeric material printable by 3D printing. Non-limiting examples of such 3D printing materials are PLA (polylactic acid), ABS (acryloni-trile butadiene styrene), PVA (polyvinyl alcohol), PP (polypropylene), PLA Tough, CPE (co-polyester), PET-G (glycol-modified polyethylene terephthalate), Nylon (polyamide) and PC (polycarbonate); preferably PLA, and even more preferably tough PLA. PLA has the advantages that it is a biodegradable and recyclable polymer that is a reliable and easy-to-print material that can be printed at low temperatures. It has a low shrinkage factor and does not require the use of a heated build plate.

All in all, the present invention entails the 3D printing of 2 pieces (a functional structure, and a piezoelectric material that can be either printed or integrated within the monolithic functional structure) as a compact single structure, such that the resulting monolithic functional structure can carry out the function of the functional structure (resonator, sensor, energy harvester) while also making use of the residual environmental energy in order to convert it into electrical energy that is transmitted to the functional structure to make use of it, providing the aforementioned advantages, which can be summarized as:

- No need for batteries or other non-renewable and wasteful energy sources.
- Making use of the residual energy of both the monolithic functional structure and its environment.
- Higher conversion efficiency of the residual energy into electric energy (due to the better mechanical and electrical connection between the piezoelectric material and the functional structure)
- Higher compactness and integration of the structure (as compared to the functional structure and the piezoelectric material as two individual components).
- Manufacturing of the whole monolithic functional structure by a single technique (3D printing) and in a single printing process.
- Both structures (functional structure and piezoelectric material) printed as a single structure.
- No need for assembly between both structures (as both structures are printed as a single piece)

This invention represents a contribution to the ongoing trends and future sustainability of self-powered functional structures, such as sensors. By harvesting ambient energy, self-powered sensors have the potential to reduce the environmental impact associated with batteries.

Last but not least, the scope of the present invention is not limited to the embodiments explicitly disclosed in this document, and the person skilled in the art understands that other embodiments which are alternative or equivalent, including modifications which are equivalent or obvious, are within the scope of protection of the present invention.

**Description of the Figures**

**Figure 1.** schematically represents the integration of a functional structure and a piezoelectric material as a single monolithic functional structure produced by 3D printing.

**Figure 2.** schematically represents the basic process of 3D printing carried out by 3D printers and their software, in order to create 3D objects.

**Figure 3.** schematically represents the different steps a-f of the Fused Deposition Modelling 3D printing process according to the present invention. The sequences of steps to create the a particular embodiment of a monolithic functional structure according to the invention are: (a) PLA base layer printing for encapsulation of the piezoelectric material; (b) placement of copper material to make the connection of the bottom electrode; (c) PLA layer printing for later assembly of the piezoelectric material; (d) placement of the piezoelectric material (PVDF); (e) printing of the rest of the PLA structure leaving two holes for subsequent connections and (f) insertion of gold connectors, for the connection of the two electrodes of the piezoelectric material.

**Figure 4.** shows pictures of a monolithic energy harvester structure with PVDF as piezoelectric material, manufactured by Fused Modelling 3D printing, according to the invention. In Figure 4 the result of the different steps of the 3D printing process according to the invention to create the monolithic energy harvester structure are shown: (a) PLA printing base layer for encapsulation of the piezoelectric material (also schematically shown in Figure 3a), and placement of copper material to make the connection of the bottom electrode (also schematically shown in Figure 3b); (b) placement of the PVDF piezoelectric material (also schematically shown in Figure 3d); (c) next, PLA layer printed after the placement of the PVDF material, leading to its partial encapsulation (also schematically shown in Figure 3e); and (d) printing of the rest of the PLA structure leaving two small regions uncovered (holes) for subsequent electrical connections (schematically shown in Figure 3e).

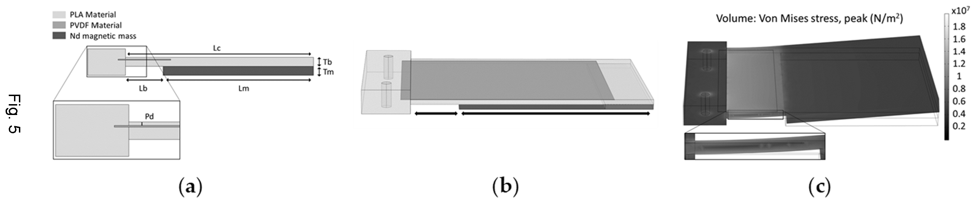

**Figure 5.** schematically shows a) a cross-section of the energy harvester with the specified dimensions; (b) a view of the 3D design used for the energy harvester; and (c) the stress distribution when the harvester resonates at its resonance frequency, and a detail of the cross-section showing the neutral axis in the software COMSOL Multiphysics®.

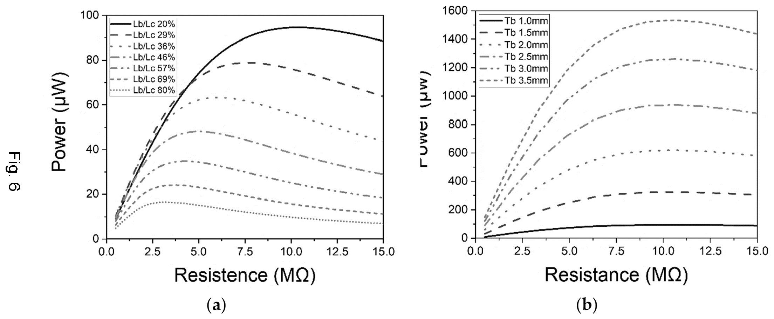

**Figure 6.** represents a graph distribution of the power (in $\mu$W) obtained from the energy piezoelectric resonant energy harvester, depending on its dimensions (Figure 6a: dimensions $L_b/L_c$; Figure 6b: dimensions $T_b$), and depending on the resistance (in M$\Omega$) from an external circuit than includes a resistor, which allows to determine the optimal load resistor in order to achieve maximum power of the piezoelectric resonant energy harvester.

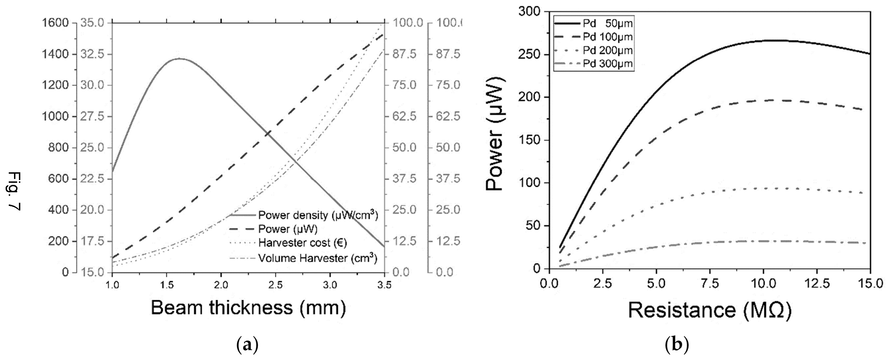

**Figure 7a.** represents a graph distribution of the simulation of the power density, power, cost and volume of the piezoelectric resonant energy harvester, depending on its beam thickness ($T_b$).

**Figure 7b.** represents a graph distribution of the simulation of the power generated by the piezoelectric resonant energy harvester depending on the depth of the piezoelectric material ($P_d$) with respect to the surface of the harvester.

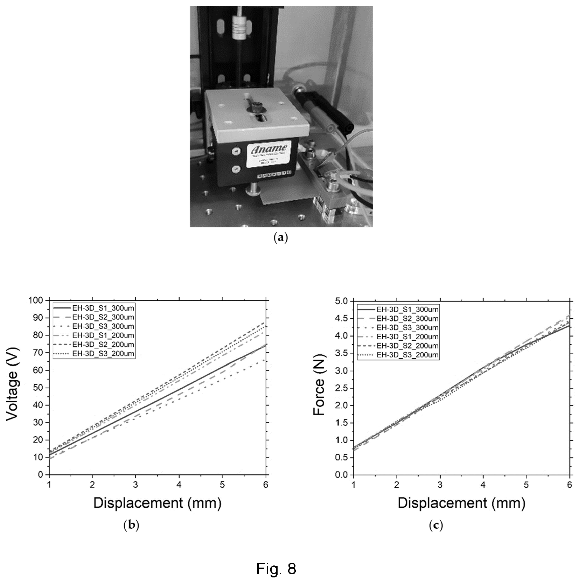

**Figure 8.** represents the first electrical characterization, namely a) the setup for the first electrical characterization using a stepper motor that performs movements of the piezoelectric resonant energy harvester, movements in position from 1mm to 6mm on the Z-axis,; b) graphical representation of the maximum voltage achieved in the setup of Figure 8a. with a displacement of the stepper motor from 1 mm to 6 mm on the Z-axis, with respect to the displacement on the Z-axis, as measured with a Sourcemeter for 6 different 3D printed energy-harvesters, three of these harvesters having their piezoelectric material at 200 $\mu$m from the surface of the energy harvester device, while the remaining other three harvesters having their piezoelectrical material at 300 $\mu$m. For each from the surface of the energy harvester device; c) Same graphical representation of the same 6 harvesters and displacement from 1-6mm, as those of Figure 8b, but where the Y-axis represents instead the force (N) measured with the displacement by a force sensor attached to the stepper motor, and recorded by means of a dynamometer.

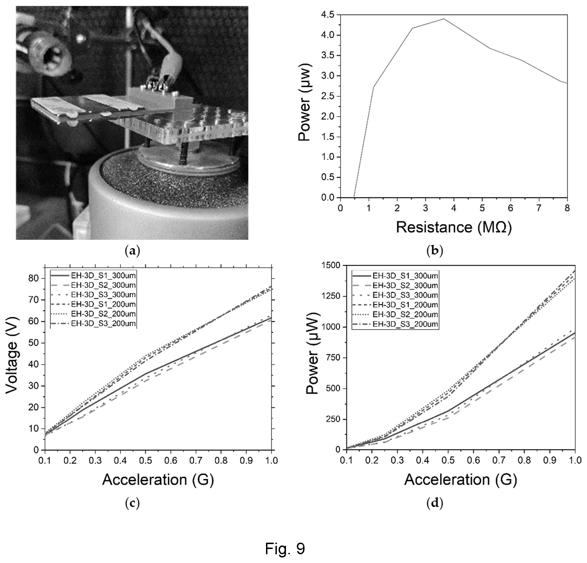

**Figure 9.** represents the second electrical characterization, namely (a) setup for the second electrical characterization using an electrodynamic shaker at 50 Hz to emulate environmental vibrations, at different input acceleration levels; (b) Optimal load resistance for maximum power generation with 0.1 G of acceleration; (c,d) Voltage and maximum power for an acceleration sweep from 0.1 G to 1 G and using a frequency of 50 Hz and an optimal load resistance of 4 M$\Omega$.

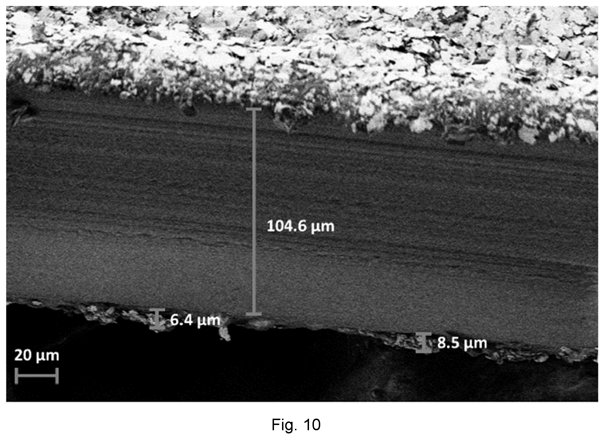

**Figure 10.** represents the physical characterization of the piezoelectric PVDF material, namely the thickness and the piezoelectric coefficient, and more precisely a SEM image of the thicknesses of the layers of the piezoelectric material.

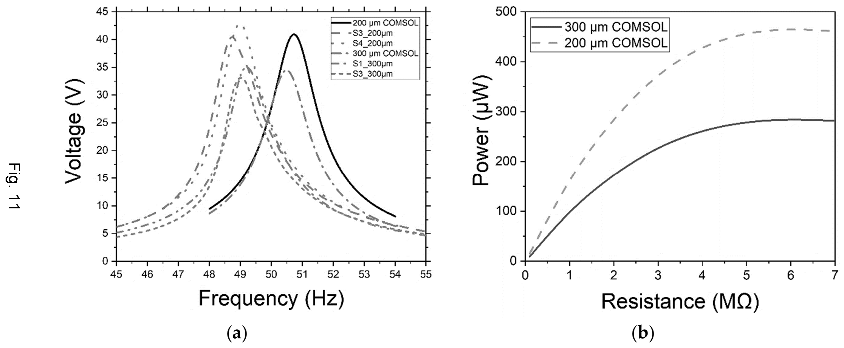

**Figure 11.** graphically represents a simulation of the variation of the output voltage (V) with frequency (Hz), of the resonant piezoelectric energy harvester comprising the piezoelectric material PVDF, by using COMSOL Multiphysics® software, with a set acceleration of 0.5 G. More precisely, Figure 11a represents a comparative of the simulated electrical characterization of the harvesters (curves plotted from 48 to 54 Hz) with the actual electrical characterization of the harvesters (curves plotted from 45 to 55 Hz), for the maximum open-circuit voltage (Y axis) that can be generated by the piezoelectric generator, for the frequency sweep plotted in the figure with an acceleration of 0.5 G. Figure 11b) represents a comparison of the maximum power generated in relation to the depth of the piezoelectric material (200$\mu$m and 300$\mu$m) and in relation of the load impedance (M$\Omega$).

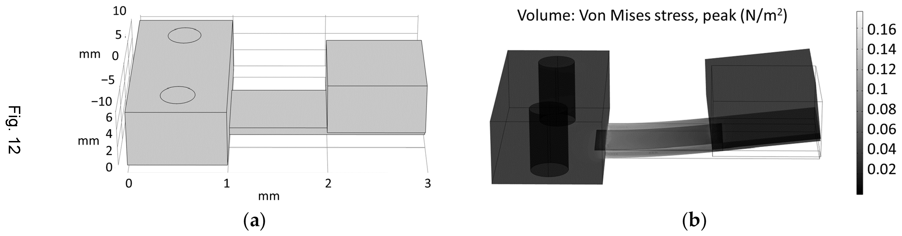

**Figure 12.** graphically represents the simulation results for the piezoelectric current sensor by using COMSOL Multiphysics® software: (a) Structure and dimensions used in the simulation; (b) 3D Finite Element modelling (FEM) simulation of the stress distribution in the cantilever beam of the piezoelectric current sensor.

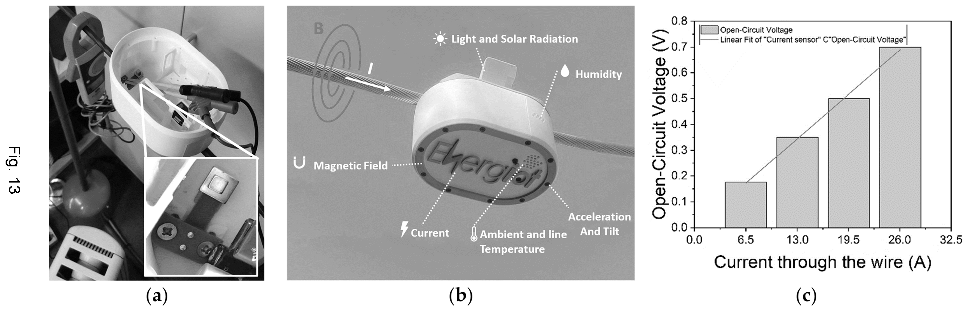

**Figure 13.** represents a picture (a) and a schematic representation (b) of a piezoelectric current sensor manufactured using 3D printing technology mounted inside a sensor node (current sensor provided by the start-up Energiot); (c) graphical representation of the open-circuit voltage generated by the piezoelectric sensor, depending on the selected power of two heaters, which can obtain up to four different currents (1500 W, 3000 W, 4500 W and 6000 W).

## EXAMPLES

A piezoelectric resonant energy harvester has been designed, fabricated, and electrically characterized. In terms of electrical characterization, it was determined that the device can achieve a maximum output power of 1.46 mW when operated with an optimal load impedance of 4 M$\Omega$ and subjected to an acceleration of 1 G.

Physical characterization of the piezoelectric material and the final resonator was also performed. In addition, a study and optimization of the device was carried out using finite element modeling (COMSOL Multiphysics®).

Finally, a proof-of-concept device (use-case resonator) was designed and fabricated with the goal of measuring the current passing through a wire.

**Material and Methods**

*1.1 Piezoelectric and Magnetic Materials*

The piezoelectric material used in the harvester is a commercially available PVDF film with two parallel electrodes, from TE Connectivity. According to the manufacturer's specification, the PVDF material has a thickness of 110 $\mu$m and 6 $\mu$m for each silver ink electrode. The piezoelectric coefficient of the commercial PVDF is -33$\times$10$^{-12}$ m/V, according to the datasheet. The selected material for the structural harvester is "Ultimaker Tough PLA green" from Ultimaker, with a Young's modulus of 2.8 $\pm$ 0.15 GPa and a density of 1.22 g/cm$^3$. A neodymium (Nd) mass with a density of 7 g/cm$^3$, from the Nd mass provider "Supermagnete", was used as magnet material. Such Nd magnet material can be observed for example in Figure 5a (Nd magnetic mass).

*1.2. Finite Element Modelling*

Finite element modeling (FEM) of the energy harvester was conducted using the software COM-SOL Multiphysics® 6.0. The AC/DC (Electrostatics, Electrical Circuits and Piezoelectricity) and Structural Mechanics (Solid Mechanics and Piezoelectricity) modules of the software, were utilized for the simulation. The model was created using a fine triangular mesh, consisting of over 25,000 elements.

*1.3. Manufacturing Process and Characterizations*

An "Ultimaker S3 printer" with AA 0.25 mm nozzle was employed for the manufacturing process, allowing printing layers from 60 $\mu$m to 150 $\mu$m thick. The initial characterization involved a stepper motor from Zaber Technologies LSQ075B-T3-MC03 (Vancouver, BC, Canada), capable of performing movements from 1 mm to 6 mm on the Z-axis. Concurrently, the voltage generated by the harvester was measured using a Sourcemeter Keithley 2470 (Cleveland, OH, USA). A force sensor Mark-10 (Copiage, NY, USA) MR03-20 fixed onto the stepper motor recorded the data with the assistance of a dynamometer Mark-10 M5I. An ad-hoc LabVIEW® program controlled the setup comprising the devices.

*1.4 Device for electrical characterizations*

The electrical characterization was conducted using an electrodynamic shaker VR9500 from Vibration Testing Controller (Jenison, MI, USA) to emulate environmental vibrations at different input acceleration magnitudes. This process was controlled by a customized MATLAB® program, enabling automation, acquisition, and processing of voltage measurements. All data were measured using an acquisition system from National Instruments (Austin, TX, USA) PCI-6132 and a BNC-2110 terminal block.
The piezoelectric coefficient of the material was measured using a Wide-Range d33 piezometer from APC International, Ltd (Mackeyville, PA, USA).

*1.5. Design of the Harvester*

*1.5.1. Definition Fixed Parameters*

There are different sources for energy harvesting, such as vibrations, human motion, residual magnetic fields, etc. In this case, we have chosen the magnetic fields generated by a current-carrying conductor. For this reason, the resonance frequency is fixed at 50 Hz (European electric grid frequency).
In order to study structure optimization, an effective area and resonance frequency of the device must be set. In this case, the dimensions are 50 mm $\times$ 40 mm (length $\times$ width).

*1.5.2. Device structure*

There are different types of structures for vibrational harvesters, such as cantilevers, doubly-supported beams, or diaphragms. The cantilever results in the highest power output when used as a piezoelectric energy harvester. Furthermore, the cantilever structure leads to the lowest resonance frequency for a given size. For this reason, the cantilever structure has been chosen.
The resonance frequency of a spring-mass system can be expressed as:

$$f_r = \frac{1}{2\pi}\sqrt{\frac{k_{eff}}{m_{eff}}}, \quad (1)$$

Here, $k_{eff}$ and $m_{eff}$ represent the effective suspension stiffness and the effective mass values, respectively.

The neutral axis of a beam is the layer in the cross-section of a beam that experiences no longitudinal strain under bending. For composite beam structures, the effect of the different materials of each layer must be summed up to find the neutral axis:

$$Z = \frac{\sum_{i=1}^{n} z_i Y_i h_i}{\sum_{i=1}^{n} Y_i h_i}, \quad (2)$$

where Z is the neutral axis position of the composite beam, $Z_i$ is the height of the centroid of layer i, $h_i$ is the thickness of layer i, and $Y_i$ is Young's modulus of layer i.

*1.6 Shape Optimizations and Finite Elements Modeling*

*1.6.1 Obtaining Resonance Frequency*

In addition to the reduction in the manufacturing cost, by having a monolithic device, anchor losses are avoided due to the improved resonator anchor structure. To achieve the desired resonance frequency, a mass with a very large thickness was required due to the low density of the PLA. Furthermore, to achieve actuation with magnetic fields by means of Lorentz's force, a ferromagnetic material is needed as a cantilever tip mass. For this reason, Neodymium (Nd) magnets have been used as an inertial mass.

As shown in Figure 5a, the harvester consists of a PLA cantilever with a length composed of the length of the beam ($L_b$), the mass ($L_m$) and the length of the cantilever ($L_c$). Moreover, the thickness of the beam has been defined as ($T_b$), the thickness of the mass as ($T_m$) and the depth of the piezoelectric material with respect to the surface as (Pd).

The 3D model shown in Figure 5b consists of the energy harvester with the piezoelectric layer inside the structure and an external circuit with a load resistor to calculate the power.

A piezoelectric material produces an electrical charge from mechanical stress. The d33 coefficient represents the piezoelectric charge coefficient along a specific direction, reflecting the material's response to applied stress. It can be expressed as:

$$d33 = \frac{\Delta Q}{\Delta S}, \quad (3)$$

From Equation (2), it can be deduced that the highest stress resulting from a beam deformation in a cantilever is located on the surface. In Figure 5c, the stress distribution is shown when the device resonates at its resonance frequency. It can be observed that the stress on the surface of the material is at its maximum, while it is zero at the center of the beam. Consequently, during the manufacturing process, it is crucial to position the encapsulated piezoelectric material as close to the surface as feasible. However, there is a trade-off, if the piezoelectric layer is too close to the surface, it will not be properly embedded and can get delaminated.

A parametric simulation of $L_b$ and $L_m$ is performed, to find the different combinations to obtain a resonance frequency of 50 Hz. The dimensions of the magnets are more restrictive because they are defined by the manufacturer. A parametric study from 10 mm to 40 mm of $L_m$ is performed. Table 1 shows the different dimension combinations obtained to achieve a resonance frequency of 50 Hz.

Table 1. Comparative with the different combinations of the parameters to obtain the fixed resonance frequency at 50Hz.

| $L_b$ (mm) | $L_m$ (mm) | $L_c$ (mm) | Ratio $L_b/L_c$ (%) | Frequency (Hz) |
|---|---|---|---|---|
| 41.20 | 10.00 | 51.20 | 80 | 50.04 |
| 33.10 | 15.00 | 48.10 | 69 | 49.95 |
| 26.80 | 20.00 | 46.80 | 57 | 50.02 |
| 21.60 | 25.00 | 46.60 | 46 | 50.00 |
| 17.15 | 30.00 | 47.15 | 36 | 50.01 |
| 13.35 | 35.00 | 45.35 | 29 | 50.05 |
| 10.20 | 40.00 | 50.20 | 20 | 49.99 |

*1.6.2 Study of Generated Power*

The voltage and power generated by the piezoelectric resonant energy harvester, depending on its different dimensions, are studied using an external circuit that includes a resistor. Performing a sweep of the external resistor, the optimal load resistor can be determined to achieve the maximum power generation for the piezoelectric resonant energy harvester. As shown in Figure 6a, the lower ratio between $L_b$ and $L_c$, the higher the power output of the piezoelectric resonant energy harvester.

A parametric thickness of the beam under the piezoelectric sheet was simulated to improve the power generated by the piezoelectric generator. Due to the increase in $L_b$, the natural frequency of the device increases. To compensate for this augment, the density or Tm must be raised. In this occasion, the density of the mass has been augmented to compensate for the frequency. In this way, the dimension of the mass is always the same and simplifies the meshing process during the simulation. As can be seen in Figure 6b, the greater $T_b$ is, the greater the power generated by the harvester.

In the next Table 2, different Tm can be seen to compensate for the increased Tb. In addition, the data of the maximum generated power, volume and power density of each harvester obtained from the simulation are also shown.

Table 2. Comparative with the different thicknesses of mass to compensate for the increased thickness of the beam and data of the maximum power generated, volume and power density of each harvester.

| $T_b$ (mm) | $T_m$ (mm) | Power ($\mu$W) | Volume (cm3) | Power Density ($\mu$W/cm$^3$) |
|---|---|---|---|---|
| 1.00 | 1.00 | 95 | 4.10 | 23.08 |
| 1.50 | 3.48 | 324 | 10.20 | 31.77 |
| 2.00 | 8.13 | 620 | 20.80 | 29.85 |
| 2.50 | 15.46 | 938 | 36.80 | 25.50 |
| 3.00 | 26.12 | 1261 | 59.60 | 21.15 |
| 3.50 | 40.40 | 1534 | 89.90 | 17.06 |

With the data obtained in the simulation shown in Table 2, the volume and cost of each harvester are calculated. As seen in Figure 7a, the cost and the volume of the harvester are closely related because most of the volume is mass. Furthermore, it can be seen how the highest power density is obtained for a $T_b$ of 1.5 mm.

Finally, a parametric simulation of the depth of the piezoelectric material from the surface of the harvester has been performed. As can be seen in Figure 7b and as mentioned above in the design section, the closer the material is to the surface, the more power it generates since it is farther from the neutral line of the beam.

With the results obtained from the simulations, it can be concluded that the best specification for the harvester is the design with a dimension of 10.2 mm $\times$ 40 mm ($L_c$ x $L_m$). In addition, to obtain a higher power density, the beam should be 1.5 mm thick and the piezoelectric material should be as close to the surface as possible.

1.7 Characterization

*1.7.1 Electrical Characterization*

Once the piezoelectric resonant energy harvesters, comprising an energy harvester as a functional structure and PVDF as the piezoelectric material, have been manufactured according to the method for 3D printing of monolithic functional structures according to the present invention, we proceed to the electrical characterization of such 3D-printed devices. Three harvesters were manufactured with the piezoelectric material at 200 μm from the surface, and other three harvesters were manufactured with the piezoelectrical material at 300 μm.

Two different electrical characterizations have been conducted.

The first characterization, shown in Figure 8a, involves a stepper motor that performs movements from 1 mm to 6 mm of distance on the Z-axis. Simultaneously, the voltage generated by the harvester is measured using a Sourcemeter. A force sensor, attached to the stepper motor, records the force data through a dynamometer. An ad-hoc LabVIEW program controls all the setup comprising these devices. As can be seen in Figure 8b, a displacement of 6 mm along the Z-axis results in an average voltage of 71.7 V for the harvester with the piezoelectric material positioned 300 μm far from the surface. Reducing the distance of the piezoelectric material from 300 μm to 200 μm increases the average voltage to 85.2 V, representing a 19% increment in the maximum voltage generated. According to the force data repre-sented in Figure 8c, the depth of the piezoelectric material does not affect the force needed to achieve 6 mm of travel at the tip of the cantilever.

For the second electrical characterization, as can be shown in Figure 9a, a magnetic mass is attached to adjust the resonance frequency to 50 Hz. An electrodynamic shaker is used to emulate environmental vibrations at different input acceleration levels. This is controlled through an ad-hoc MATLAB program that allows automatizing, acquiring and processing the voltage measurements. All these data are captured by an acquisition system. Subsequently, fixing a certain acceleration magnitude, a sweep of load resistors values is performed. This allows us to determine the optimal load resistor value for the highest generated power.

Due to the voltage limitations of the acquisition system, which cannot measure voltages exceeding 10 V, the load resistance sweep is initially carried out with a small acceleration of 0.1 G, ensuring that it remains below 10 V. Figure 9b shows that the optimal load resistance for maximum power generation is 4 MΩ, resulting a maximum power of 4.4 μW.

Once the optimal load resistance is known, a voltage divider is used, composed of a set of 500 KΩ and 3.5 MΩ resistors. It is possible to measure the voltages generated by harvesters with accelerations greater than 0.1 G.

The voltage generated by the piezoelectric generator was measured while performing an acceleration sweep ranging from 0.1 G to 1 G, as shown in Figure 9c. For an acceleration of 1 G, the harvester with the piezoelectric material positioned 300 μm from the surface achieved an average voltage of 62.3 V. By reducing the distance of the piezoelectric material to 200 μm, an average voltage of 75.6 V is achieved, resulting in a 21.4% increase in the maximum voltage generated. Using the aforementioned voltage data, the maximum power for the different accelerations was calculated and plotted in Figure 9d. It can be observed that reducing the difference between the two depths of the piezoelectric material resulted in an increase of up to 47.3% in the maximum power generated. This led to a maximum output power of 1.46 mW.

*1.7.2 Physical Characterization of the PVDF material*

An inspection using a scanning electron microscope (SEM) was performed to validate the thickness of the materials provided by the manufacturer and, as can be seen in Figure 10a, the measured thickness closely matches the manufacturer specifications.

Using a piezometer, we can measure the exact coefficient of our PVDF piece. As shown in Figure 10b, the coefficient is the same as the manufacturer's specifications.

*1.7.3. Measurement of Young's modulus of the functional structure material (PLA)*

The Young's modulus of the PLA used to 3D print the piezoelectric resonant energy harvesters of the examples is 2.8 ± 0.15 GPa, as stated in the technical datasheet. When introducing a material within the PLA, the overall effective Young's modulus can be changed, depending on the resulting combination of materials. Therefore, the Young's modulus of the harvesters will be calculated based on the force data measured with a stepper motor displacement from the previous section.

displacement of a cantilever beam $\delta$ is related to the applied load (P), and the Young modulus (E), according to the next Equation (4):

$$\delta \;=\; \frac{1}{3}\,\frac{PL^3}{EI}, \quad (4)$$

where L is the length of the cantilever, and I the second moment of inertia. The second moment of inertia (I) quantifies the resistance of the transversal section against bending, with respect to that transversal axis.

For a prismatic beam with a rectangular section (depth h and with w) the value of the second moment of inertia of cantilever beam I is given by:

$$I \; = \; \frac{wh^3}{12} \; = \; \frac{0.04 \; m \; x \; 0.0015 \; m^3}{12} \; = \; 11.25x10^{-12} \; m^4, \quad (5)$$

From Equation (4) and using the force data measured with stepper motor displacement, the Young's modulus of harvesters is calculated:

$$E \; = \; \frac{1}{3} \frac{PL^3}{\delta I} \; = \; \frac{4.5 \; N \; x \; 0.05 \; m^3}{3 \; x \; 0.006 \; m \; x \; 11.25x10^{-12} \; m^4} \; = \; 2.78 \; GPa, \quad (6)$$

From the Young's modulus obtained from the above Equation (6), it can be seen that the modulus is within the manufacturer's specifications and that the piezoelectric material has little effect on the final Young's modulus of the harvesters.

*1.8 Finite Elements Simulation*

The energy harvesters were simulated again with COMSOL Multiphysics® to compare the results of the electrical characterization with a theoretical model. Physical parameters such as Young's modulus, thickness, coefficient of the piezoelectric material, and harvester dimensions were included in the simulation to achieve a realistic representation.

A parametric sweep ranging from 48 Hz to 54 Hz was performed to determine the resonance frequency of the resonators with an optimal load resistance of 4 MΩ. In figure 11a a comparative of the simulated electrical characterization of the harvesters (curves plotted from 48 to 54 Hz) with the actual electrical characterization of the harvesters (curves plotted from 45 to 55 Hz), for the maximum open-circuit voltage (Y axis) that can be generated by the piezoelectric generator, for the frequency sweep plotted in the figure with an acceleration of 0.5 G. The resonance frequency for the simulated harvesters with the software COMSOL Multiphysics® was approximately 50.5 Hz, while the electrical characterization of the manufactured harvesters yielded a resonance frequency of 49.5 Hz. Initially, the harvesters were tuned to resonate at 50 Hz with an acceleration of 0.1 G. However, due to spring softening with increasing acceleration, the resonance frequency is shifted from 0.5 Hz to 49.5 Hz.

As in the electrical characterization with the shaker, a sweep of the load resistance is performed to calculate the maximum power. As shown in the Figure 11b, which graphically represents a comparison of the maximum power generated in relation to the depth of the piezoelectric material (200μm and 300μm) and in relation of the load impedance (MΩ), the maximum power generation is around 5 MΩ, with a maximum power of 283 μW for the harvester with a 300 μm distance of the piezoelectric material and 464 μW for the 200 μm distance. These values are very similar to the maximum powers measured in Figure 9c, with 288 μW and 462 μW, respectively.

*1.9. Example of Application*

As mentioned earlier, the energy harvester can be customized using CAD software (e.g Tinkercard, https://www.tinkercad.com) to adapt its specifications for various application scenarios. An example application for the monolithic functional structure of the invention, with PVDF as the piezoelectric material, could instead use as the functional structure a sensor (rather than an energy harvester).

In this particular case (using a sensor as the functional structure), the sensor can be employed to measure the current flowing through the wire of a high-voltage tower. When an electric current passes through the wires, it generates a magnetic field that is directly proportional to the current flowing through the wire. Moreover, by using a magnetic mass (for example, two magnetic masses of Neodimium with dimensions 10x10x2.7 mm), the monolithic sensor structure with PVDF as the piezoelectric material, can be made to resonate, and depending on the current it passes, we can measure an instantaneous proportional voltage in our sensor.

In this example of application, the maximum dimensions for the sensor are 30 mm × 20 mm with a height of 10 mm. The resonance frequency for this resonator is the same as the frequency of the current flowing through the wire being measured, which is 50 Hz. The magnets for the magnetic mass have dimensions of 10 mm × 10 mm and a thickness of 2.7 mm. The support will be fixed at dimensions of 20 mm × 10 mm and a height of 10 mm to ensure good anchoring and easy fastening. A simulation is performed to obtain the resonance frequency at 50 Hz. As shown in Figure 12a, measurements of 12 mm × 20 mm and a thickness of 700 μm for the cantilever beam are obtained. Two magnets, for example two magnetic masses of Neodimium with dimensions 10x10x2.7 mm, will be required for the magnetic mass. Figure 12b shows the stress distribution in the beam when the cantilever is resonating at an acceleration of 0.1 G.

As can be shown in Figure 13a and Figure 13b, the simulated sensor is mounted inside a sensor node provided by the startup company "Energiot Devices SL" (www.energiot.com). To test the sensor in the laboratory, two heaters with two power selections have been connected. This setup allows for the generation of four different currents depending on the selected power: 1500 W (6.5 A), 3000 W (13 A), 4500 W (19.5 A) and 6000 W (26 A). As can be seen in Figure 13c, the different current cases passing through the cable can be measured using the corresponding voltage readings, demonstrating a linear response.

Furthermore, the magnetic field can also be used to power wireless sensors that measure various parameters such as magnetic field, ambient and line temperature, acceleration, tilt, humidity and light intensity and transmit the gathered information to the cloud.

*Summary of the Example*

In this example, a resonant piezoelectric energy harvester by exploiting 3D printing technology and encapsulating PVDF within the structure, resulting in a monolithic harvester, was designed, manufactured, and physically and electrically characterized. With this, an economically viable energy harvester was achieved that mechanically improves the anchoring of the resonator thanks to its structure attached to the fixing support. The device was optimized through the finite element simulation software COMSOL Multiphysics® 6.0.

Furthermore, an example of the practical application of the resonator by designing and fabricating a specific use case for measuring the current passing through a wire using magnetic fields, was demonstrated. It was shown that 3D printing enabled the manufacturing of a compact monolithic functional structure (i.e. a monolithic harvester, and also facilitated its customization and optimization for specific requirements.

Overall, this example provides a practical approach to designing and manufacturing resonant harvesters using 3D printing. The demonstrated use case application shows the potential to use such devices in a myriad of real-world scenarios.

**Claims**

1. A monolithic functional structure, **characterized in that** it comprises:

   • at least a functional structure made of a functional structure material; and
   • at least a piezoelectric material;
   • wherein the functional structure and the piezoelectric material are part of a single piece;
   • wherein the functional structure and the piezoelectric material are electrically connected; and
   • wherein the piezoelectric material is not located along the neutral axis of the monolithic functional structure.

2. Monolithic functional structure according to claim 1, wherein the functional structure material is selected from PLA, ABS, PVA, PP, Tough PLA, CPE, PET-G, Nylon, PC and any combination thereof.

3. Monolithic functional structure according to claims 1 or 2, wherein the piezoelectric material of the monolithic functional structure is selected from zirconate titanate, polyvinylidene fluoride or their copolymers, copolymer of polyvinylidene fluoride and trifluoroethylene (PVDF-TrFE), copolymer of polyvinylidene fluoride and tetrafluoroethylene (PVDF-TrFE), or combinations thereof.

4. Monolithic functional structure according to any of the previous claims, which additionally comprises at least a substrate on top of which the functional structure and the piezoelectric material are located, wherein the substrate material is selected from glass.

5. Monolithic functional structure according to any of the previous claims, wherein the functional structure of the monolithic functional structure is a low power sensor.

6. Monolithic functional structure according to any of the previous claims, wherein the monolithic functional structure is a monolithic energy harvester structure with PVDF as the piezoelectric material.

7. Monolithic functional structure according to any of the previous claims, wherein the at least one functional structure and the at least one piezoelectric material are at least in partial physical contact with each other.

8. Monolithic functional structure according to any of the previous claims, **characterized in that** comprises from bottom to top:

• at least a first layer of functional structure material comprising at least one layer of printed structural material, wherein a region of the said layer of functional structure material is left empty as a depression, wherein a metal layer, preferably copper, applied in such region;

• at least a second layer of functional structure material comprising at least one layer of printed structural material on top of the first layer of functional structure material, wherein at least the top of the metal layer is left uncovered;

• a layer of piezoelectric material on top of the first layer of functional structure material, at least partially in contact with the metal layer;

• at least a third layer of functional structure material comprising at least one layer of printed structural material on top of the piezoelectric material layer and on top of the second layer of functional structure material, wherein at least a region on the top of the metal layer and a region on the top of the piezoelectric material layer are left uncovered;

• an electrical connector selected from a metal wire or a metal spring load, located in both of the regions left uncovered on top of the metal layer and on top of the piezoelectric material layer.

9. Method for the 3D printing of monolithic functional structures according to any of the previous claims, **characterized in that** it comprises the steps of:

    a. providing a substrate, preferably a glass substrate;

    b. printing at least one layer of a first functional structure material that comprising at least one layer of printed structural material on the substrate of the step (a), preferably PLA, without applying functional structure material to at least a region of the last printing layer;

    c. applying metal in such a region of the step (b), preferably copper,

    d. optionally, printing at least one layer of a second functional structure material that comprising at least one layer of printed structural material, preferably PLA, without applying functional structure material at least on top of the region where the metal has been applied in step (c);

    e. applying a piezoelectric material, preferably polyvinylidene fluoride, on top of the layer where the metal has been applied in step (c), preferably at least partially in direct contact with the metal;

    f. printing at least one layer of a third functional structure material that comprising at least one layer of printed structural material, preferably PLA, without applying functional structure material on top of at least a region of the metal of step (c) and on top of at least a region of the piezoelectric material of step (e), and

    g. placing at least an electrical connector in both of the regions left uncovered on top of the metal and on top of the piezoelectric material of step (f).

10. Method according to claim 9, wherein the 3D printing is carried out by Fused Deposition Modelling.

11. Method according to claim 9 or 10, wherein computer-implemented design (CAD) software is used in order to design the monolithic functional structure to be 3D printed.

12. Method according to any of claims 9 to 11, wherein a model created by computer-implemented design (CAD) software is sliced into layers using slicing software.

13. Method according to any of claims 9 to 12, wherein the applied metal in step c) of the method is selected from gold, silver, or copper, preferably copper.

14. Method according to any of claims 9 to 13, wherein the at least one electrical connector placed in both of the regions, in step g) of the method, is selected from a metal wire or a metal spring load.

15. Method according to claim 14, wherein the metal of the metal wire or metal spring load is selected from gold, silver, or copper, preferably copper.

16. Method according to any of claims 9 to 15, wherein the functional structure material is selected from PLA (polylactic acid), ABS (acrylonitrile butadiene styrene), PVA (polyvinyl alcohol), PP (polypropylene), PLA Tough, CPE (co-polyester), PET-G (glycol-modified polyethylene terephthalate), Nylon (polyamide) and PC (polycarbonate); preferably PLA, and even more preferably tough PLA.

17. Use of monolithic functional structure according to any of claims 1 to 5 or 7 to 8, as a sensor, low-power sensor, energy harvester or actuator.

**18.** Use of the monolithic functional structure according to claim 17 as a low-power sensor for the creation of a large wireless network wherein the low-power sensors communicate with each other.

Fig. 1

Fig. 2

Fig. 3

Fig. 4

Fig. 5

Fig. 6

Fig. 7

(a)

(b)

(c)

Fig. 8

Fig. 9

Fig. 10

(a)

(b)

Fig. 11

EP 4 761 552 A1

Volume: Von Mises stress, peak (N/m²)

0.16
0.14
0.12
0.1
0.08
0.06
0.04
0.02

(b)

(a)

Fig. 12

Fig. 13

## INTERNATIONAL SEARCH REPORT

| International application No. |
|---|
| PCT/ES2024/070500 |

**A. CLASSIFICATION OF SUBJECT MATTER**

See extra sheet

According to International Patent Classification (IPC) or to both national classification and IPC

**B. FIELDS SEARCHED**

Minimum documentation searched (classification system followed by classification symbols)
H10N, H02N

Documentation searched other than minimum documentation to the extent that such documents are included in the fields searched

Electronic data base consulted during the international search (name of data base and, where practicable, search terms used)

EPODOC, INVENES, WPI, NPL, XPESP, COMPENDEX, MEDLINE

**C. DOCUMENTS CONSIDERED TO BE RELEVANT**

| Category* | Citation of document, with indication, where appropriate, of the relevant passages | Relevant to claim No. |
|---|---|---|
| X | LOZANO MONTERO, K., et al., Self-Powered, Ultrathin, and Transparent Printed Pressure Sensor for Biosignal Monitoring, ACS Applied Electronic Materials, 26/10/2021, Vol. 3, N° 10, pp 4362 - 4375, ISSN 2637-6113 (electronic), <DOI: doi:10.1021/acsaelm.1c00540>; abstract; paragraph: "Experimental Section"; figures. | 1-18 |
| X | DUQUE, M., et al., Optimization of a Piezoelectric Energy Harvester and Design of a Charge Pump Converter for CMOS-MEMS Monolithic Integration, Sensors, 21/04/2019, Vol. 19, N° 8, ISSN 1424-8220 (Electronic), <DOI: doi:10.3390/s19081895 pubmed:31010076>; abstract; paragraph: "Piezoelectric MEMS Energy Harvester"; figures. | 1-18 |
| X | TOPRAK, A., et al., Micron scale energy harvesters using multiple piezoelectric polymer layers, Sensors and Actuators A: Physical, 01/01/2018, Vol. 269, pp 412 - 418, ISSN 0924-4247, <DOI: doi:10.1016/j.sna.2017.11.035>; abstract; paragraph: "Experimental Section"; figures. | 1-18 |

☒ Further documents are listed in the continuation of Box C.     ☒ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance. | | |
| "E" | earlier document but published on or after the international filing date | | |
| "L" | document which may throw doubts on priority claim(s) or which is cited to establish the publication date of another citation or other special reason (as specified) | "X" | document of particular relevance; the claimed invention cannot be considered novel or cannot be considered to involve an inventive step when the document is taken alone |
| "O" | document referring to an oral disclosure use, exhibition, or other means. | "Y" | document of particular relevance; the claimed invention cannot be considered to involve an inventive step when the document is combined with one or more other documents , such combination being obvious to a person skilled in the art |
| "P" | document published prior to the international filing date but later than the priority date claimed | | |
| | | "&" | document member of the same patent family |

| Date of the actual completion of the international search | Date of mailing of the international search report |
|---|---|
| 07/01/2025 | **(09/01/2025)** |

| Name and mailing address of the ISA/ | Authorized officer |
|---|---|
| OFICINA ESPAÑOLA DE PATENTES Y MARCAS<br>Paseo de la Castellana, 75 - 28071 Madrid (España)<br>Facsimile No.: 91 349 53 04 | M. García Poza<br><br>Telephone No. 913495568 |

Form PCT/ISA/210 (second sheet) (July 2022)

## INTERNATIONAL SEARCH REPORT

International application No.

PCT/ES2024/070500

| C (continuation). | DOCUMENTS CONSIDERED TO BE RELEVANT | |
|---|---|---|
| Category * | Citation of documents, with indication, where appropriate, of the relevant passages | Relevant to claim No. |
| A | EP 3876386 A1 (DOLIAM CAIRDAC) 08/09/2021, abstract. | 1-18 |
| A | WO 2019195264 A1 (UNIV KANSAS et al.) 10/10/2019, abstract. | 1-18 |
| A | WO 2014172617 A1 (UNIV CORNELL) 23/10/2014, abstract. | 1-18 |

Form PCT/ISA/210 (continuation of second sheet) (July 2022)

## INTERNATIONAL SEARCH REPORT

Information on patent family members

International application No.

PCT/ES2024/070500

| Patent document cited in the search report | Publication date | Patent family member(s) | Publication date |
|---|---|---|---|
| EP3876386 A1 | 08.09.2021 | CN113346791 A | 03.09.2021 |
| | | CN113346791B B | 15.12.2023 |
| | | US2021273587 A1 | 02.09.2021 |
| | | US11626816 B2 | 11.04.2023 |
| | | FR3107792 A1 | 03.09.2021 |
| | | FR3107792 B1 | 14.10.2022 |
| WO2019195264 A1 | 10.10.2019 | US2021367134 A1 | 25.11.2021 |
| | | US12120959 B2 | 15.10.2024 |
| WO2014172617 A1 | 23.10.2014 | US2019214543 A1 | 11.07.2019 |
| | | US2016072041 A1 | 10.03.2016 |
| | | US10158063 B2 | 18.12.2018 |

Form PCT/ISA/210 (patent family annex) (July 2022)

**INTERNATIONAL SEARCH REPORT**

| | |
|---|---|
| International application No. | |
| PCT/ES2024/070500 | |

CLASSIFICATION OF SUBJECT MATTER

*H10N30/05* (2023.01)
*H10N39/00* (2023.01)
*H02N2/18* (2006.01)
*H10N30/30* (2023.01)
*H10N30/50* (2023.01)

Form PCT/ISA/210 (extra sheet) (July 2022)